# FASCICULE DE BREVET EUROPEEN

(11) **EP 2 091 092 B1**
(45) Date de publication et mention de la délivrance du brevet: **12.05.2010**
(21) Numéro de dépôt: 09305066.4
(22) Date de dépôt: 26.01.2009
(51) Int. Cl.: H01L 43/12, H01L 43/08

(54) **Procédé pour réaliser un nanocontact d'une vanne de spin entrant dans la constitution d'un oscillateur radio fréquence**
Verfahren zur Erzeugung eines Nanokontakts in einem Spinventil zur Verwendung bei der Herstellung eines Radiofrequenzoszillators
Method of establishing a nanocontact of an in-spin valve to be used in the manufacture of a radiofrequency oscillator

(30) Priorité: 13.02.2008 FR 0850906
(43) Date de publication de la demande: 19.08.2009
(73) Titulaire: Commissariat à l'énergie atomique et aux énergies alternatives, 75015 Paris (FR)
(72) Inventeur: Cyrille, Marie-Claire, 38650 Sinard (FR); Ponthenier, Fabienne, 38800 Champagnier (FR)
(74) Mandataire: Vuillermoz, Bruno

(56) Documents cités:
- US-A- 5 695 864
- OZATAY O ET AL: "Spin transfer by nonuniform current injection into a nanomagnet" APPLIED PHYSICS LETTERS, AIP, AMERICAN INSTITUTE OF PHYSICS, MELVILLE, NY, vol. 88, no. 20, 18 mai 2006 (2006-05-18), pages 202502-202502, XP012081730 ISSN: 0003-6951
- MANCOFF F B ET AL: "Phase-locking in double-point-contact spin-transfer devices" NATURE NATURE PUBLISHING GROUP UK, vol. 437, no. 7057, 15 septembre 2005 (2005-09-15), pages 393-395, XP002497339 ISSN: 0028-0836
- RIPPARD W H ET AL: "Current-driven microwave dynamics in magnetic point contacts as a function of applied field angle" PHYSICAL REVIEW B (CONDENSED MATTER AND MATERIALS PHYSICS) APS THROUGH AIP USA, vol. 70, no. 10, 1 septembre 2004 (2004-09-01), pages 100406-1, XP002497340 ISSN: 0163-1829
- KISELEV S I ET AL: "Microwave oscillations of a nanomagnet driven by a spin-polarized current" NATURE, NATURE PUBLISHING GROUP, LONDON, UK, vol. 425, 25 septembre 2003 (2003-09-25), pages 380-383, XP002329287 ISSN: 0028-0836

## Description

### DOMAINE DE L'INVENTION

L'invention appartient au domaine des oscillateurs radio fréquence mettant en oeuvre des vannes de spin.

Elle vise plus particulièrement la réalisation de nanocontacts intégrant un injecteur métallique venant au contact de la vanne de spin, et destiné à permettre de soumettre ladite vanne de spin à un courant électrique d'excitation en vue de générer une oscillation du moment magnétique de l'une des couches magnétiques qui la constituent.

### ETAT ANTERIEUR DE LA TECHNIQUE

Les oscillateurs radio fréquence sont destinés à fonctionner dans des gammes de fréquences élevées, typiquement comprises entre le GHz et plusieurs dizaines de GHz.

Afin de satisfaire les exigences nées du développement, notamment des téléphones mobiles (cellulaires), portables, outre de la saturation des bandes de fréquences attribuées à la télécommunication, on a proposé de remplacer l'allocation statique desdites bandes de fréquences par une allocation dynamique. Ce principe repose sur la capacité d'analyser le spectre de fréquences, d'identifier les bandes de fréquence libres, afin de pouvoir les utiliser. On parle alors de radio opportuniste.

Cependant, afin de mettre en oeuvre ce principe d'allocation dynamique de fréquences, les dispositifs les mettant en oeuvre doivent disposer d'oscillateurs à très larges bandes, et par ailleurs être très performants en bruit de phase, et donc à fort coefficient de qualité Q=f/Δf.

Une solution technique propre à satisfaire ces exigences consiste en la mise en oeuvre d'oscillateurs radio fréquence à électronique de spin. Avec de tels oscillateurs, on dispose d'une large bande de fréquence avec un facteur de qualité Q élevé, outre une accordabilité en fréquence aisée et mettant en oeuvre une architecture relativement simple.

L'électronique de spin utilise le spin des électrons comme degré de liberté supplémentaire, afin de générer des effets nouveaux. La polarisation en spin d'un courant électrique est à l'origine de phénomènes magnétorésistifs dans les multicouches magnétiques, telle que la magnétorésistance géante ou la magnétorésistance tunnel.

On a montré qu'en faisant passer un courant polarisé en spin à travers une couche mince magnétique, on pouvait induire un renversement de son aimantation en l'absence de tout champ magnétique externe. Le courant polarisé en spin peut également générer des excitations magnétiques entretenues, également dénommées oscillations. L'utilisation de l'effet de génération d'excitations magnétiques entretenues dans un dispositif magnéto-résistif permet de convertir cet effet en une modulation de résistance électrique directement utilisable dans les circuits électroniques, et donc corollairement, susceptible d'intervenir directement au niveau de la fréquence.

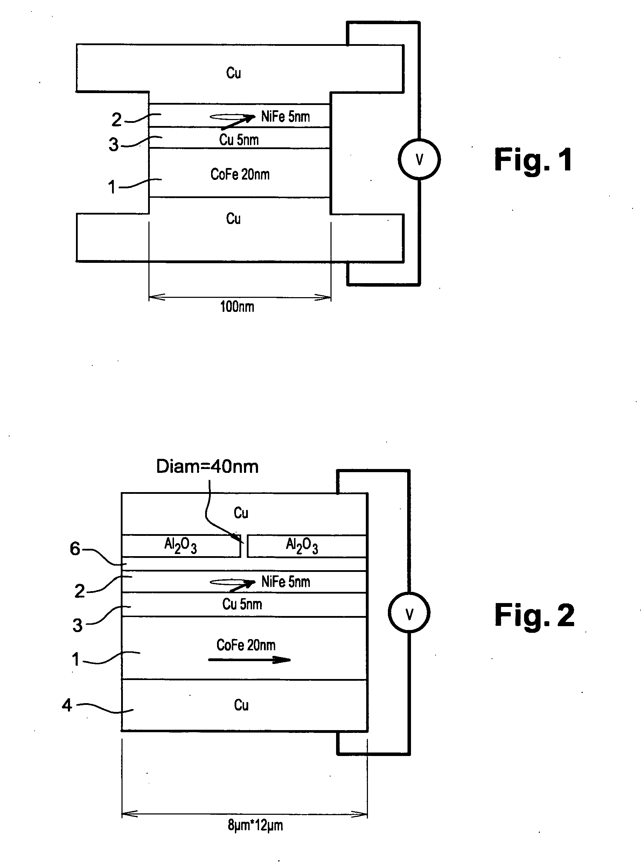

Le document US 5,695,864 décrit divers développements mettant en oeuvre le principe physique mentionné ci-dessus, et décrit notamment la précession de l'aimantation d'une couche magnétique traversée par un courant électrique polarisé en spin. On a représenté en relation avec les figures 1 et 2 deux types d'empilement des couches magnétiques susceptibles de constituer un tel oscillateur radio fréquence. Ces empilements sont insérés entre deux arrivées de courant, dont le contact avec les deux couches extrêmes est par exemple réalisé en cuivre ou en or.

La couche **1** de cet empilement, dite « couche piégée », présente une aimantation à orientation fixe. Elle peut être une couche simple, d'épaisseur typique comprise entre 5 et 100 nanomètres, par exemple réalisée en cobalt, en alliage CoFe ou NiFe. Cette couche piégée **1** peut être simple ou synthétique. Elle remplit fondamentalement la fonction de polariseur. Ainsi, les électrons du courant électrique traversant les couches constitutives du dispositif magnéto-résistif perpendiculairement à leur plan, réfléchis ou transmis par le polariseur, sont polarisés avec une direction de spin parallèle à l'aimantation qu'à la couche **1** à l'interface opposée à celle en contact avec une couche antiferromagnétique **4,** à laquelle elle est associée, et destinée à figer l'orientation de son aimantation.

En outre, cette couche **1** reçoit sur sa face opposée à la face recevant la couche antiferromagnétique **4** une autre couche **3** faisant fonction d'espaceur.

Cette couche **3** est de nature métallique, typiquement une couche de cuivre de 3 à 10 nanomètres d'épaisseur, ou est constituée d'une fine couche isolante de type oxyde d'aluminium, d'une épaisseur typique comprise entre 0,5 à 1,5 nanomètre, ou d'oxyde de magnésium, d'une épaisseur typique comprise entre 0,5 à 3 nanomètres.

De l'autre côté de l'espaceur **3,** est mise en place une couche **2,** généralement d'épaisseur plus faible de que celle de la couche **1.** Cette couche **2** peut également être couplée à une couche antiferromagnétique **6** rapportée sur celle-ci au niveau de sa face opposée à l'interface de la couche **2** avec l'espaceur **3.** Cette couche **6** est par exemple constituée d'alliage du type Ir₈₀Mn₂₀, de FeMn ou de PtMn.

Avantageusement, le matériau mis en oeuvre pour la couche **2** présente une forte constante de raideur d'échange. Ce matériau est typiquement un métal 3d, et plus particulièrement du cobalt ou des alliages riches en cobalt.

Les empilements magnétorésistifs mis en oeuvre pour la réalisation de tels oscillateurs utilisent des empilements réalisés de deux manières différentes :
- les empilements dits « en pilier » : l'ensemble des couches est gravé pour réaliser un pilier de diamètre de l'ordre de 50 à 100 nanomètres ;
- les empilements dits « point contact » : dans un tel empillement, les couches actives (couche **1,** couche **2,** couche **3,** voire les couches en matériau antiferromagnétique) ne sont pas gravées avec des motifs nanométriques ou si elles le sont, sont alors fabriquées selon des motifs très grands (voisins du micromètre carré) ; on réalise un contact métallique très étroit, typiquement 50 nanomètres, au dessus de la couche **2** ou de la couche antiferromagnétique qui lui est associée, au moyen d'une nanopointe externe (par exemple pointe du microscope à force atomique ou injecteur) ou interne, pilier lithographié.

Les nanocontacts sont préférés lorsqu'on met en oeuvre des vannes de spin, car ils produisent des émissions radio fréquence mieux définies, et notamment des émissions radio fréquence plus fines. En effet, on a pu observer une diminution de la largeur des raies d'émission RFs, que l'on attribue à la minimisation des effets de bord dus au procédé de fabrication, et à l'augmentation du volume des couches libres.

La réalisation des nanocontacts implique généralement la fabrication d'un nano-injecteur métallique au dessus de la vanne de spin, ou d'un nano-trou réalisé dans un diélectrique, qui est rempli par la suite par du métal. La vanne de spin doit en outre être patternée pour former des composants élémentaires. La réalisation de ces nanocontacts implique donc au moins deux étapes de lithographie, à savoir une pour la réalisation d'un nanocontact et une pour la réalisation de la vanne de spin avec les contraintes d'alignement entre le nanocontact et la vanne de spin, également deux séquences de gravures distinctes et deux séquences distinctes d'élimination de résine (stripping en anglais).

Ce faisant, la réalisation de tels nanocontacts complexifie de manière importante la réalisation de l'oscillateur, surenchérissant les coûts et augmentant la durée du process.

L'objectif visé par la présente invention vise à simplifier la réalisation de tels nanocontacts.

### EXPOSE DE L'INVENTION

Le procédé conforme à l'invention pour réaliser un nanocontact sur une vanne de spin aux fins de constituer un oscillateur radio fréquence consiste, après dépôt, par exemple par pulvérisation cathodique ou par canon ionique, de l'empilement magnétique constitutif de la vanne de spin sur une électrode inférieure :
- à déposer sur ledit empilement magnétique une couche métallique dite couche « d'arrêt », destinée à stopper l'étape de gravure, intervenant subséquemment ;
- à déposer sur cette couche « d'arrêt » une autre couche métallique destinée à constituer ultérieurement l'injecteur d'un nanocontact proprement dit ;
- à déposer localement sur cette couche métallique un masque dur, destiné à localiser les couches sous-jacentes ;
- à soumettre l'ensemble à une première étape de gravure sélective de la couche métallique constitutive de l'injecteur au travers du masque dur, ladite couche « d'arrêt » servant d'arrêt à cette étape de gravure, ladite couche métallique étant surgravée au cours de cette étape sous le masque dur afin de conférer au nanocontact sa forme définitive ;
- à soumettre l'ensemble ainsi obtenu à une deuxième étape de gravure sélective apte à induire l'élimination partielle de ladite couche « d'arrêt » et de l'empilement magnétique sensiblement à la périphérie du masque dur ;
- à encapsuler l'ensemble obtenu dans un diélectrique ;
- à planariser l'ensemble encapsulé ainsi obtenu jusqu'à aboutir à l'aplomb de la couche résiduelle du masque dur ou de l'injecteur ;
- et enfin à mettre en place l'électrode supérieure conductrice.

En d'autres termes, l'invention consiste à combiner en une seule séquence de photolithographie la nanofabrication de l'injecteur et celle du plot magnétique constitutif de la vanne de spin, de sorte que l'injecteur se trouve ainsi aligné automatiquement sur ledit plot magnétique.

On conçoit dès lors tout d'abord et fondamentalement, l'élimination des contraintes d'alignement intervenant lorsque l'on met en oeuvre deux étapes de photolithographie conformément au procédé de réalisation du nanocontact de l'art antérieur.

On aboutit également à une diminution du nombre d'étapes de fabrication, aboutissant à un gain de temps et à une réduction des coûts.

Enfin, le procédé conforme à l'invention permet de réaliser un contrôle efficace des dimensions pour la réalisation des plots magnétiques, typiquement inférieurs à 100 nanomètres, voire inférieurs à 50 nanomètres, là où la mise en oeuvre de la photolithographie permet difficilement de contrôler les dimensions.

Selon l'invention, le dépôt de la couche d'arrêt de gravure est réalisé par pulvérisation cathodique ou par canon ionique. Cette couche d'arrêt est typiquement constituée par une couche d'aluminium de 10 à 20 nanomètres d'épaisseur.

Selon l'invention, le dépôt de la couche métallique propre à constituer l'injecteur proprement du est réalisé également par pulvérisation cathodique ou par canon ionique, le métal constitutif dudit injecteur étant du tantale, du molybdène ou du titane.

Selon l'invention, on dépose localement sur la couche constitutive du masque dur une couche de résine et l'on soumet l'ensemble ainsi obtenu à une étape de photolithographie

En outre, la première étape de gravure sélective est par exemple réalisée par gravure ionique réactive.

Toujours selon l'invention, la deuxième étape de gravure sélective est par exemple réalisée par faisceau d'ions (mieux connue sous l'expression anglo-saxonne « gravure IBE » pour « *Ion Beam Etching* »).

Toujours selon l'invention, le dépôt de la couche destinée à constituer le masque dur est réalisé par pulvérisation cathodique en courant continu, le masque dur étant typiquement constitué d'une couche de chrome, de ruthénium ou d'aluminium de 10 à 50 nanomètres d'épaisseur ou d'une couche d'un oxyde, par exemple Al₂O₃ ou SiO₂.

L'étape de photolithographie est réalisée avantageusement par DUV (selon l'expression anlgo-saxonne « *Deep ultraviolet* » ou « ultraviolet profond »), ou électronique afin de définir des plots de dimensions typiquement comprises entre 100 et 300 nanomètres.

Selon l'invention, le dimensionnement respectivement de la couche résiduelle du masque dur et du diamètre de l'injecteur est réalisé par sélection de la chimie chlorée pour le masque dur et par chimie fluorée, type SF₆ ou CHF₃ ou CF₄ pour l'injecteur, déterminé en outre par la durée de la gravure. L'attaque de la couche d'arrêt de la gravure est effectuée par gravure IBE, ainsi que celle de l'empilement magnétique sous jacent.

Selon l'invention, l'encapsulation par diélectrique est avantageusement effectuée en deux étapes :
- une première étape par dépôt ALD (selon l'expression anglo-saxonne *« Atomique Layer Deposition* », c'est-à-dire technique de dépôt de couche atomique),
- puis une seconde étape par dépôt par pulvérisation cathodique ou par canon ionique.

La première étape de dépôt, réalisée par ALD permet, par son caractère très conformant, d'épouser le relief de surface et d'assurer le dépôt d'un diélectrique de très bonne qualité. La deuxième étape de dépôt, par pulvérisation, permet de compléter l'encapsulation, dans un délai moindre.

Le matériau diélectrique est typiquement constitué d'alumine, Al₂O₃ ou de silice SiO₂.

Selon l'invention, l'empilement magnétique constitutif de la vanne de spin comprend :
■ une première couche magnétique dite « couche piégée », dont l'aimantation est de direction fixe,
■ une seconde couche magnétique,
■ une couche amagnétique, interposée entre les deux couches précédentes, destinée à faire fonction d'espaceur, et destinée à découpler magnétiquement lesdites couches.

Avantageusement, ladite seconde couche magnétique est constituée d'une couche simple à laquelle est associée une couche anti-ferromagnétique, cette dernière étant placée sur la face de ladite seconde couche opposée à la couche amagnétique faisant fonction d'espaceur, le matériau constitutif de la couche anti-ferromagnétique étant choisi dans le groupe comprenant les alliages suivants : Ir₂₀Mn₈₀, FeMn et PtMn. En variante, la seconde couche magnétique peut être une couche synthétique, couplée ou non à une couche antiferromagnétique.

Avantageusement, ladite première couche magnétique dite couche « piégée », faisant fonction de polariseur, est constituée par une couche simple, dont le piégeage est assuré par l'association à une couche anti-ferromagnétique, notamment réalisée en IrMn ou PtMn, rapportée sur sa face opposée à l'interface de ladite couche avec la couche amagnétique.

### BREF DESCRIPTION DES FIGURES

La manière dont l'invention peut être réalisée et les avantages qui en découlent, ressortiront mieux de l'exemple de réalisation qui suit, donné à titre indicatif et non limitatif, à l'appui des figures annexées.
Les figures 1 et 2 sont, comme déjà dit, des représentations schématiques d'un oscillateur radio fréquence conforme à l'état antérieur de la technique.
Les figures 3A à 3G sont destinées à illustrer les différentes étapes du procédé conforme à l'invention.

### MODE DE REALISATION DE L'INVENTION

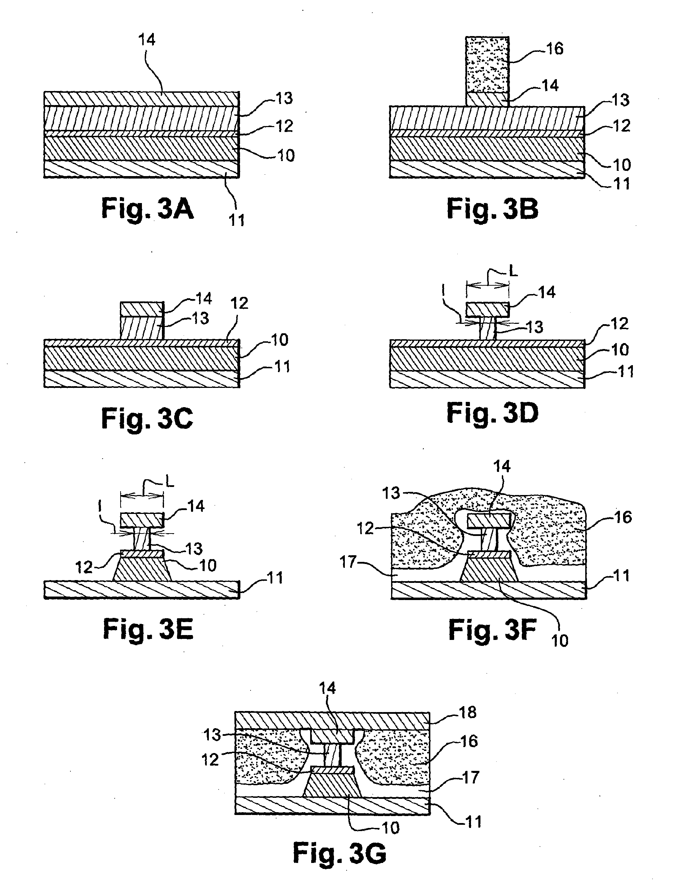

On a donc représenté en relation avec les figures 3A à 3G les différentes étapes du procédé de réalisation d'un nanocontact conforme à l'invention.

Lors de l'étape 3A, on suppose que l'empilement magnétique **10** du type décrit en relation avec les figures 1 et 2 a d'ores et déjà été déposé sur l'électrode inférieure **11.** Ce dépôt a pu être réalisé, par exemple, par pulvérisation cathodique ou par canon ionique.

On procède tout d'abord au dépôt sur l'empilement **10** d'une couche **12** d'un matériau métallique, typiquement de l'aluminium, destinée s'opposer à l'action de la gravure intervenant subséquemment, et donc à protéger provisoirement l'empilement magnétique 10 lors de ladite étape de gravure.

Cette couche « d'arrêt » **12** est typiquement réalisée en aluminium par pulvérisation cathodique ou par canon ionique et présente une épaisseur comprise entre 5 et 20 nanomètres, par exemple 10 nanomètres.

Après dépôt de cette couche, on procède au dépôt d'une couche métallique **13,** destinée à constituer l'injecteur du nanocontact de l'oscillateur, c'est-à-dire par le biais duquel va transiter le courant polarisé en spin.

Le dépôt de cette couche est également réalisé par exemple par pulvérisation cathodique ou par canon ionique.

Le métal mis en oeuvre est typiquement constitué de tantale, de molybdène, de tungstène ou de titane. L'épaisseur de cette couche est comprise entre 50 et 200 nanomètres.

Enfin, on dépose sur cette couche **13** un masque dur localisé **14,** destiné à servir de masque lors de la gravure des couches sous-jacentes. Pour ce faire, on peut, comme illustré à la figure 3A, déposer une couche continue **14,** par exemple de chrome ou de ruthénium ou d'aluminium, que l'on vient ensuite graver. On peut ainsi par exemple déposer sur la couche **14** une résine **15** que l'on localise à l'aplomb de ce qui servira de base à l'injecteur en la soumettant à une étape de photolithographie sous rayons ultraviolets profonds ou sous faisceau d'électrons. On obtient ainsi des plots de résine, dont le diamètre typique est compris entre 100 et 300 nanomètres.

Ces plots sont ensuite utilisés pour graver sélectivement la couche **14** (figure 3B) et ainsi former le masque dur. Une étape facultative d'élimination de la résine **15** peut être prévue à ce stade.

On procède ensuite à une première gravure de la couche **13** constitutive de l'injecteur au travers du masque dur **14** pour conférer à cette couche métallique **13** ses dimensions définitives. A cet effet, on peut procéder tout d'abord à une gravure ionique réactive (RIE) du chrome constitutif du masque dur par chimie chlorée (par exemple sous Cl₂ ou HBr/Cl₂), réduisant l'épaisseur de cette couche **14.** Puis, on procède (figure 3C) à une gravure RIE de la couche métallique **13** par chimie fluorée SF₆ ou CHF₃ ou CF₄ avec arrêt sélectif sur la couche d'arrêt **12** faisant fonction de couche d'arrêt de la gravure.

On poursuit la gravure RIE, comme illustré figure 3D, jusqu'à obtenir une surgravure latérale de la couche métallique **13,** afin de réduire ses dimensions latérales par rapport au masque dur **14,** et ainsi aboutir à la dimension voulue de l'injecteur. Pour ce faire, on agit au niveau de la durée de la gravure. On peut typiquement augmenter de 20 à 50% le temps de gravure par rapport au temps nécessaire pour atteindre la couche d'arrêt **12.**

Lors de l'étape illustrée à la figure 3E, on procède à une deuxième gravure, par exemple IBE (« *Ion Beam Etching* »), au travers du masque dur **14,** afin de supprimer d'une part, la couche **12** d'arrêt de la gravure située en dehors de la zone située à l'aplomb du masque dur **14,** et d'autre part, l'empilement magnétique **10** situé en dehors de cette même zone. Cette gravure IBE peut se faire par exemple sous gaz Argon ou Xénon, avec un angle d'incidence compris entre 5 et 50 degrés.

On procède alors à l'encapsulation de l'ensemble résultant de cette dernière étape (figure 3F). Cette encapsulation est réalisée, au moyen d'un matériau diélectrique, type silice ou alumine. Cette encapsulation peut être réalisée par dépôt PVD (dépôt physique en phase vapeur, « *Physical Vapor Deposition* »).

Avantageusement, cette encapsulation est réalisée en deux étapes :
■ une première étape, réalisée par dépôt atomique **17** (ALD) d'une épaisseur typique comprise entre 30 et 60 nanomètres ;
■ puis une seconde étape, réalisée par pulvérisation cathodique ou par canon ionique 16 d'une épaisseur de 100 à 300 nanomètres

Le dépôt ALD présente l'avantage d'être très conformant, ce qui permet d'épouser parfaitement le relief de la structure obtenue à la figure 3E et notamment le surplomb sous le masque **14** au niveau de l'injecteur **13.** Ce dépôt est complété ensuite par un dépôt par pulvérisation cathodique ou par canon ionique, plus rapide. On aboutit alors à l'ensemble illustré sur la figure 3F.

On soumet alors l'ensemble ainsi obtenu à une étape de planarisation par CMP (polissage mécano-chimique, selon l'acronyme anglo-saxon *« Chemical Mechanical Polishing* ») jusqu'à aboutir au niveau du nanoplot **14** pour permettre alors le dépôt de l'électrode supérieure **18.**

Dans ce cas, le nanoplot doit être électriquement conducteur afin d'assurer le contact entre l'électrode supérieure **18** et l'injecteur **13.**

En variante, il est possible de poursuivre la planarisation jusqu'à atteindre l'injecteur **13.** Dans ce cas, le nanoplot **14** est éliminé lors de cette étape, un choix plus large de matériau est alors possible pour le masque dur **14,** notamment des matériaux isolant comme SiO₂ ou Al₂O₃.

On conçoit aisément qu'en raison du procédé conforme à l'invention, on élimine les contraintes d'alignement puisque l'injecteur **13** est automatiquement aligné avec l'empilement magnétique **10.**

Au surplus, il est possible grâce au procédé de l'invention d'aboutir à des nanoplots de dimensions réduites, typiquement inférieurs à 100 nanomètres, voire à 50 nanomètres, et propres a optimiser les conditions de fonctionnement de l'oscillateur radio fréquence en résultant.

## Revendications

1. Procédé pour réaliser un nanocontact sur une vanne de spin aux fins de constituer un oscillateur radio fréquence, consistant, après dépôt de l'empilement magnétique constitutif de la vanne de spin sur une électrode inférieure (11) :
- à déposer sur ledit empilement magnétique (10) une couche métallique dite couche « d'arrêt » (12), destinée à stopper l'étape de gravure, intervenant subséquemment ;
- à déposer sur cette couche « d'arrêt » (12) une autre couche métallique (13) destinée à constituer ultérieurement l'injecteur d'un nanocontact proprement dit ;
- à déposer localement sur cette couche métallique (13) un masque dur (14), destiné à localiser la gravure des couches sous-jacentes ;
- à soumettre l'ensemble à une première étape de gravure sélective de la couche métallique (13) constitutive de l'injecteur au travers du masque dur (14), la couche « d'arrêt » (12) servant d'arrêt à cette étape de gravure, ladite couche métallique (13) étant surgravée au cours de cette étape sous le masque dur afin de conférer au nano-contact sa dimension définitive ;
- à soumettre l'ensemble ainsi obtenu à une deuxième étape de gravure sélective, apte à induire l'élimination partielle de la couche d'arrêt (12) et de l'empilement magnétique (10) sensiblement à la périphérie du masque dur ;
- à encapsuler l'ensemble obtenu dans un diélectrique (16, 17) ;
- à planariser l'ensemble encapsulé ainsi obtenu jusqu'à aboutir à l'aplomb de la couche résiduelle du masque dur (14) ou de l'injecteur (13) ;
- et enfin à mettre en place l'électrode supérieure conductrice (18).

2. Procédé pour réaliser un nanocontact sur une vanne de spin selon la revendication 1, ***caractérisé* en ce que** le dépôt de la couche « d'arrêt » de gravure (12) est réalisé par pulvérisation cathodique ou par canon ionique.

3. Procédé pour réaliser un nanocontact sur une vanne de spin selon l'une des revendications 1 et 2, ***caractérisé* en ce que** la couche « d'arrêt » de gravure (12) est constituée par une couche d'aluminium de 5 à 20 nanomètres d'épaisseur.

4. Procédé pour réaliser un nanocontact sur une vanne de spin selon l'une des revendications 1 à 3, ***caractérisé* en ce que** le dépôt de la couche métallique (13) propre à constituer l'injecteur proprement dit est réalisé par pulvérisation cathodique ou par canon ionique.

5. Procédé pour réaliser un nanocontact sur une vanne de spin selon l'une des revendications 1 à 4, ***caractérisé* en ce que** l'on dépose localement sur la couche constitutive du masque dur (14) une couche de résine (15), et **en ce que** l'on soumet l'ensemble ainsi obtenu à une étape de photolithographie.

6. Procédé pour réaliser un nanocontact sur une vanne de spin selon l'une des revendications 1 à 5, ***caractérisé* en ce que** la première étape de gravure sélective est réalisée par gravure ionique réactive.

7. Procédé pour réaliser un nanocontact sur une vanne de spin selon l'une des revendications 1 à 6, ***caractérisé* en ce que** la deuxième étape de gravure sélective est réalisée par faisceau d'ions.

8. Procédé pour réaliser un nanocontact sur une vanne de spin selon l'une des revendications 1 à 7, ***caractérisé* en ce que** le métal constitutif de l'injecteur (13) est choisi dans le groupe comprenant le tantale, le molybdène, le tungstène et le titane.

9. Procédé pour réaliser un nanocontact sur une vanne de spin selon l'une des revendications 1 à 8, ***caractérisé* en ce que** le dépôt de la couche (14) destinée à constituer le masque dur est réalisé par pulvérisation cathodique en courant continu.

10. Procédé pour réaliser un nanocontact sur une vanne de spin selon l'une des revendications 1 à 9, ***caractérisé* en ce que** la couche (14) constitutive du masque dur est constitué d'un matériau choisi dans le groupe comprenant le chrome, l'aluminium, le ruthénium, la silice (SiO₂) et l'alumine (Al₂O₃).

11. Procédé pour réaliser un nanocontact sur une vanne de spin selon l'une des revendications 1 à 10, ***caractérisé* en ce que** l'épaisseur de la couche (14) constitutive du masque dur présente une épaisseur comprise entre 10 et 50 nanomètres.

12. Procédé pour réaliser un nanocontact sur une vanne de spin selon l'une des revendications 1 à 11, ***caractérisé* en ce que** le dimensionnement du diamètre de l'injecteur est réalisé par chimie fluorée, type SF₆ ou CHF₃ ou CF₄ pour l'injecteur lors d'une étape de gravure, le diamètre dudit injecteur étant en outre ajusté par la durée de ladite gravure.

13. Procédé pour réaliser un nanocontact sur une vanne de spin selon l'une des revendications 1 à 12, ***caractérisé* en ce que** la phase d'encapsulation par diélectrique est effectuée en deux étapes :
- une première étape par dépôt de couche atomique,
- puis une seconde étape par dépôt par pulvérisation cathodique ou par canon ionique.

14. Procédé pour réaliser un nanocontact sur une vanne de spin selon l'une des revendications 1 à 13, ***caractérisé* en ce que** le matériau diélectrique d'encapsulation est choisi dans le groupe comprenant l'alumine et la silice.

15. Procédé pour réaliser un nanocontact sur une vanne de spin selon l'une des revendications 1 à 14, ***caractérisé* en ce que** l'empilement magnétique (10) comprend :
- une première couche magnétique dite «couche piégée» (1), dont l'aimantation est de direction fixe,
- une seconde couche magnétique (2),
- une couche amagnétique (3) interposée entre les deux couches précédentes, destinée à faire fonction d'espaceur, et destinée à découpler magnétiquement lesdites couches.

16. Procédé pour réaliser un nanocontact sur une vanne de spin selon la revendication *15,* ***caractérisé* en ce que** la seconde couche magnétique (2) est constituée d'une couche simple à laquelle est associée une couche anti-ferromagnétique (6), cette dernière étant placée sur la face de ladite couche (2) opposée à la couche amagnétique (3) faisant fonction d'espaceur, le matériau constitutif de la couche anti-ferromagnétique (6) étant choisi dans le groupe comprenant les alliages suivants : Ir₂₀Mn₈₀, FeMn et PtMn.

17. Procédé pour réaliser un nanocontact sur une vanne de spin selon l'une des revendications 15 et 16, ***caractérisé* en ce que** la première couche magnétique (1) dite couche piégée, faisant fonction de polariseur, est constituée par une couche simple, dont le piégeage est assurée par l'association à une couche anti-ferromagnétique, notamment réalisée en IrMn ou PtMn (4), rapportée sur sa face opposée à l'interface de ladite couche (1) avec la couche amagnétique (3).

## Claims

1. A method for making a nano-contact on a spin valve for the purposes of constituting a radio-frequency oscillator, consisting, after deposition of the magnetic stack constituting the spin valve on a lower electrode (11):
- in depositing on said magnetic stack (10) a metal layer known as a "barrier" layer (12), intended to halt the etching step, that occurs subsequently;
- in depositing onto this "barrier" layer (12) another metal layer (13) intended subsequently to constitute the injector a nano-contact strictly speaking;
- in depositing locally on this metal layer (13) a hard mask (14), intended to confine the etching of the subjacent layers;
- in subjecting the assembly to a first selective etching step of the metal layer (13) constituting the injector through the hard mask (14), the "barrier" layer (12) acting to halt this etching step, said metal layer (13) being over-etched during this step under the hard mask in order to give the nano-contact its final dimension;
- in subjecting the assembly so obtained to a second selective etching step, able to induce the partial removal of the barrier layer (12) and of the magnetic stack (10) substantially on the periphery of the hard mask;
- in encapsulating the assembly obtained in a dielectric (16, 17);
- in planarizing the encapsulated assembly so obtained until ending plumb with the residual layer of the hard mask (14) or of the injector (13);
- and finally in putting the conductive upper electrode (18) in place.

2. The method for making a nano-contact on a spin valve as claimed in claim 1, **characterized in that** the etching "barrier" layer (12) is deposited by cathode sputtering or by ion gun.

3. The method for making a nano-contact on a spin valve as claimed in one of claims 1 and 2, **characterized in that** the etching "barrier" layer (12) is constituted by a layer of aluminium from 5 to 20 nanometres thick.

4. The method for making a nano-contact on a spin valve as claimed in one of claims 1 to 3, **characterized in that** the metal layer (13) suitable for constituting the actual injector is deposited by cathode sputtering or by ion gun.

5. The method for making a nano-contact on a spin valve as claimed in one of claims 1 to 4, **characterized in that** a layer of resin (15) is deposited locally on the layer constituting the hard mask (14), and **in that** the assembly so obtained is subjected to a photolithography step.

6. The method for making a nano-contact on a spin valve as claimed in one of claims 1 to 5, **characterized in that** the first selective etching step is implemented by reactive ion etching.

7. The method for making a nano-contact on a spin valve as claimed in one of claims 1 to 6, **characterized in that** the second selective etching step is implemented by ion beam.

8. The method for making a nano-contact on a spin valve as claimed in one of claims 1 to 7, **characterized in that** the metal constituting the injector (13) is selected from the group including tantalum, molybdenum, tungsten and titanium.

9. The method for making a nano-contact on a spin valve as claimed in one of claims 1 to 8, **characterized in that** the layer (14) intended to constitute the hard mask is deposited by direct current cathode sputtering.

10. The method for making a nano-contact on a spin valve as claimed in one of claims 1 to 9, **characterized in that** the layer (14) constituting the hard mask is constituted by a material selected from the group including chromium, aluminium, ruthenium, silica (SiO₂) and alumina (Al₂O₃).

11. The method for making a nano-contact on a spin valve as claimed in one of claims 1 to 10, **characterized in that** the layer (14) constituting the hard mask is between 10 and 50 nanometres thick.

12. The method for making a nano-contact on a spin valve as claimed in one of claims 1 to 11, **characterized in that** the injector diameter is sized by fluorination chemistry, type SF₆ or CHF₃ or CF₄ for the injector during an etching step, the diameter of said injector being further adjusted by the duration of said etching.

13. The method for making a nano-contact on a spin valve as claimed in one of claims 1 to 12, **characterized in that** the encapsulation by dielectric phase is implemented in two steps:
- a first step by atomic layer deposition,
- and then a second step by cathode sputtering or ion gun deposition.

14. The method for making a nano-contact on a spin valve as claimed in one of claims 1 to 13, **characterized in that** the dielectric encapsulation material is selected from the group including alumina and silica.

15. The method for making a nano-contact on a spin valve as claimed in one of claims 1 to 14, **characterized in that** the magnetic stack (10) includes:
- a first magnetic layer known as a "trapped layer" (1), whereof the magnetization is of fixed direction,
- a second magnetic layer (2),
- a nonmagnetic layer (3) interposed between the two previous layers, intended to function as spacer, and intended to decouple said layers magnetically.

16. The method for making a nano-contact on a spin valve as claimed in claim 15, **characterized in that** the second magnetic layer (2) is constituted by a single layer with which is associated an anti-ferromagnetic layer (6), the latter being placed on the face of said layer (2) opposite the nonmagnetic layer (3) functioning as spacer, the material constituting the anti-ferromagnetic layer (6) being selected from the group including the following alloys: Ir₂₀Mn₈₀, FeMn and PtMn.

17. The method for making a nano-contact on a spin valve as claimed in one of claims 15 and 16, **characterized in that** the first magnetic layer (1) known as the trapped layer, functioning as polarizer, is constituted by a single layer, with the trapping being ensured by the association with an anti-ferromagnetic layer, particularly made out of IrMn or PtMn (4), added to its face opposite the interface of said layer (1) with the nonmagnetic layer (3).

## Patentansprüche

1. Verfahren zur Herstellung eines Nanokontakts auf einem Spinventil, um einen Funkfrequenzoszillator zu bilden, das darin besteht, nach dem Aufbringen des das Spinventil bildenden Magnetpakets auf eine untere Elektrode (11):
- auf das Magnetpaket (10) eine Stoppschicht (12) genannte Metallschicht aufzubringen, die dazu bestimmt ist, den anschließend zum Tragen kommenden Ätzschritt zu stoppen;
- auf diese Stoppschicht (12) eine weitere Metallschicht (13) aufzubringen, die dazu bestimmt ist, zu einem späteren Zeitpunkt den Injektor eines eigentlichen Nanokontakts zu bilden;
- auf diese Metallschicht (13) lokal eine Hartmaske (14) aufzubringen, die dazu bestimmt ist, die Ätzung der darunter liegenden Schichten zu lokalisieren;
- die Einheit einem ersten selektiven Ätzschritt der den Injektor bildenden Metallschicht (13) durch die Hartmaske (14) hindurch zu unterziehen, wobei die Stoppschicht (12) diesem Ätzschritt als Sperre dient, wobei die Metallschicht (13) im Verlauf dieses Schritts unter der Hartmaske überätzt wird, um dem Nanokontakt seine endgültige Abmessung zu verleihen;
- die so erhaltene Einheit einem zweiten selektiven Ätzschritt zu unterziehen, der im Wesentlichen am Umfang der Hartmaske die teilweise Beseitigung der Stoppschicht (12) und des Magnetpakets (10) herbeizuführen vermag;
- die erhaltene Einheit in einem Dielektrikum (16, 17) zu verkapseln;
- die so erhaltene verkapselte Einheit bis zum Erzielen der Lotrechten der Restschicht der Hartmaske (14) oder des Injektors (13) zu planarisieren;
- und schließlich die obere, leitende Elektrode (18) einzusetzen.

2. Verfahren zur Herstellung eines Nanokontakts auf einem Spinventil nach Anspruch 1, ***dadurch gekennzeichnet, dass*** das Aufbringen der Ätzstoppschicht (12) mittels Kathodenzerstäubung oder einer Ionenkanone erfolgt.

3. Verfahren zur Herstellung eines Nanokontakts auf einem Spinventil nach einem der Ansprüche 1 und 2, ***dadurch gekennzeichnet, dass*** die Ätzstoppschicht (12) aus einer 5 bis 20 nm dicken Aluminiumschicht gebildet ist.

4. Verfahren zur Herstellung eines Nanokontakts auf einem Spinventil nach einem der Ansprüche 1 bis 3, ***dadurch gekennzeichnet, dass*** das Aufbringen der Metallschicht (13), die sich dazu eignet, den eigentlichen Injektor zu bilden, mittels Kathodenzerstäubung oder einer Ionenkanone erfolgt.

5. Verfahren zur Herstellung eines Nanokontakts auf einem Spinventil nach einem der Ansprüche 1 bis 4, ***dadurch gekennzeichnet, dass*** auf die Schicht, welche die Hartmaske (14) bildet, lokal eine Harzschicht (15) aufgebracht wird, und dass die so erhaltene Einheit einem Fotolithografieschritt unterzogen wird.

6. Verfahren zur Herstellung eines Nanokontakts auf einem Spinventil nach einem der Ansprüche 1 bis 5, ***dadurch gekennzeichnet, dass*** der erste selektive Ätzschritt mittels reaktiver Ionenätzung erfolgt.

7. Verfahren zur Herstellung eines Nanokontakts auf einem Spinventil nach einem der Ansprüche 1 bis 6, ***dadurch gekennzeichnet, dass*** der zweite selektive Ätzschritt mittels Ionenstrahl erfolgt.

8. Verfahren zur Herstellung eines Nanokontakts auf einem Spinventil nach einem der Ansprüche 1 bis 7, ***dadurch gekennzeichnet, dass*** das den Injektor (13) bildende Metall aus der Gruppe ausgewählt ist, die Tantal, Molybdän, Wolfram und Titan umfasst.

9. Verfahren zur Herstellung eines Nanokontakts auf einem Spinventil nach einem der Ansprüche 1 bis 8, ***dadurch gekennzeichnet, dass*** das Aufbringen der Schicht (14), die dazu bestimmt ist, die Hartmaske zu bilden, mittels Gleichstrom-Kathodenzerstäubung erfolgt.

10. Verfahren zur Herstellung eines Nanokontakts auf einem Spinventil nach einem der Ansprüche 1 bis 9, ***dadurch gekennzeichnet, dass*** die Schicht (14), welche die Hartmaske bildet, aus einem Material besteht, das aus der Gruppe ausgewählt ist, die Chrom, Aluminium, Ruthenium, Siliziumoxid (SiO₂) und Aluminiumoxid (Al₂O₃) umfasst.

11. Verfahren zur Herstellung eines Nanokontakts auf einem Spinventil nach einem der Ansprüche 1 bis 10, ***dadurch gekennzeichnet, dass*** die Dicke der Schicht (14), welche die Hartmaske bildet, eine Dicke zwischen 10 und 50 nm aufweist.

12. Verfahren zur Herstellung eines Nanokontakts auf einem Spinventil nach einem der Ansprüche 1 bis 11, ***dadurch gekennzeichnet, dass*** die Dimensionierung des Durchmessers des Injektors mittels Fluorchemie des Typs SF₆ oder CHF₃ oder CF₄ für den Injektor während eines Ätzschritts erfolgt, wobei der Durchmesser des Injektors darüber hinaus durch die Dauer dieser Ätzung eingestellt wird.

13. Verfahren zur Herstellung eines Nanokontakts auf einem Spinventil nach einem der Ansprüche 1 bis 12, ***dadurch gekennzeichnet, dass*** die Verkapselungsphase mittels Dielektrikum in zwei Schritten erfolgt:
- einem ersten Schritt durch Aufbringen einer Atomschicht,
- dann einem zweiten Schritt durch Aufbringen mittels Kathodenzerstäubung oder einer Ionenkanone.

14. Verfahren zur Herstellung eines Nanokontakts auf einem Spinventil nach einem der Ansprüche 1 bis 13, ***dadurch gekennzeichnet, dass*** das dielektrische Verkapselungsmaterial aus der Gruppe ausgewählt ist, die Aluminium- und Siliziumoxid umfasst.

15. Verfahren zur Herstellung eines Nanokontakts auf einem Spinventil nach einem der Ansprüche 1 bis 14, ***dadurch gekennzeichnet, dass*** das Magnetpaket (10) umfasst:
- eine erste Magnetschicht (1), die Fangschicht genannt wird, deren Magnetisierung eine feststehende Richtung hat,
- eine zweite Magnetschicht (2),
- eine zwischen den beiden vorhergehenden Schichten eingesetzte, nicht magnetische Schicht (3), die dazu bestimmt ist, als Abstandhalter zu fungieren und die besagten Schichten magnetisch zu entkoppeln.

16. Verfahren zur Herstellung eines Nanokontakts auf einem Spinventil nach Anspruch 15, ***dadurch gekennzeichnet, dass*** die zweite Magnetschicht (2) aus einer einfachen Schicht besteht, der eine antiferromagnetische Schicht (6) zugeordnet ist, wobei diese Letztgenannte auf der Seite der Schicht (2) angeordnet ist, die der als Abstandhalter fungierenden, nicht magnetischen Schicht (3) entgegengesetzt ist, wobei das die antiferromagnetische Schicht (6) bildende Material aus der die folgenden Legierungen umfassenden Gruppe ausgewählt ist: Ir₂₀Mn₈₀, FeMn und PtMn.

17. Verfahren zur Herstellung eines Nanokontakts auf einem Spinventil nach einem der Ansprüche 15 und 16, ***dadurch gekennzeichnet, dass*** die erste, Fangschicht genannte Magnetschicht (1), die als Polarisator fungiert, aus einer einfachen Schicht besteht, deren Einfangwirkung durch die Zuordnung zu einer antiferromagnetischen, insbesondere aus IrMn oder PtMn hergestellten Schicht (4) sichergestellt ist, die auf deren der Grenzfläche der Schicht (1) mit der nicht magnetischen Schicht (3) entgegengesetzten Seite aufgebracht ist.
